(19) **Europäisches Patentamt / European Patent Office / Office européen des brevets**

(11) **EP 1 881 046 A2**

(12) **EUROPEAN PATENT APPLICATION**

(43) Date of publication:
**23.01.2008 Bulletin 2008/04**

(51) Int Cl.:
*C09J 109/06* [(2006.01)]   *C09J 133/06* [(2006.01)]

(21) Application number: **07014114.8**

(22) Date of filing: **18.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **18.07.2006 JP 2006195429**

(71) Applicant: **NITTO DENKO CORPORATION Osaka (JP)**

(72) Inventors:
• **Kazuyuki, Kiuchi**
  **Ibaraki-shi**
  **Osaka (JP)**
• **Tomokazu, Takahashi**
  **Ibaraki-shi**
  **Osaka (JP)**

(74) Representative: **Grünecker, Kinkeldey, Stockmair & Schwanhäusser Anwaltssozietät Maximilianstrasse 58 80538 München (DE)**

(54) **Heat-resistant dicing tape or sheet**

(57)    The present invention relates to a heat-resistant dicing tape or sheet, which includes a substrate having a glass transition temperature of 70°C or higher; and at least one pressure-sensitive adhesive layer disposed on at least one side of the substrate, the pressure-sensitive adhesive layer having a degree of weight loss upon heating of less than 2% when the pressure-sensitive adhesive layer is heated from room temperature to 200°C at a rate of temperature increase of 2°C/min, in which the pressure-sensitive adhesive layer has an adhesive force (peel rate: 300 mm/min; peel angle: 180°) of 0.5 N/20 mm or lower when the heat-resistant dicing tape or sheet is applied to a silicon mirror wafer, is subsequently heated at 200°C for 30 seconds, and is then cooled to 23°C.

**EP 1 881 046 A2**

**Description**

**FIELD OF THE INVENTION**

The present invention relates to a heat-resistant pressure-sensitive adhesive tape or sheet for use in semiconductor wafer dicing, and a semiconductor part obtained with using the same.

**BACKGROUND OF THE INVENTION**

Semiconductor devices including a silicon substrate or compound substrate, an active layer formed on one side of the substrate, and electrodes or a metal film for improving heat radiation characteristics formed on the other side of the substrate include devices of various kinds, such as discrete devices, e.g., IGBTs, high-frequency amplifiers, and vertical-electrode semiconductors, e.g., LEDs. Because of large thickness of conventional substrate, it has hitherto been possible to employ a technique which includes adhering a protective tape (back grinding tape) to the active side, subsequently conducting back-side grinding, stripping off the protective tape, and then conducting back-side metal deposition at a high temperature by sputtering or the like.

However, along with the recent trend toward performance advancement in semiconductor devices, the silicon, compound, and other substrates are becoming thinner and the technique heretofore in use is becoming difficult to cope with it. Namely, problems, for example, that the wafer breaks during conveyance have become conspicuous when backside deposition is conducted after the protective tape has been stripped off after back-side grinding. Under such circumstances, techniques have been proposed in which a semiconductor wafer in the state of being supported by a pedestal wafer is subjected to thickness reduction and back-side deposition to thereby overcome the problem concerning conveyance. Of these, the pedestal technique employing a heat-peelable pressure-sensitive adhesive sheet has been proposed as a pedestal technique attaining satisfactory self-stripping properties.

However, the use of a heat-peelable pressure-sensitive adhesive sheet has had the following problem. When a dicing tape is adhered to the semiconductor wafer side of a thin semiconductor wafer having a pedestal wafer attached thereto and the pedestal wafer is thereafter separated with heating, then the heat is transferred also to the dicing tape. Because of this, in the case of ordinary dicing tapes employing PVC, a polyolefin, or the like as the substrate, the adhesive force increases considerably or substrate melting occurs. Furthermore, with the decrease in thickness, even semiconductor wafers which are not of the both-side-electrode type have come, in some cases, to be subjected to a probe test on a dicing tape with beating. In particular, there is a growing desire for a dicing tape having heat resistance.

In addition, as shown in Patent Document 1, it is necessary to apply a dicing tape to the semiconductor wafer immediately after the back-side grinding of the semiconductor wafer and then peel off the back grinding tape from the semiconductor wafer in some cases, depending on the process. In this case, it is desirable that electric test (conduction test) on the wafer is conducted in a condition that the wafer is attached to the dicing tape in view of the efficiency.

Patent Document 1 : JP-A-2005-116610

**SUMMARY OF THE INVENTION**

An object of the invention is to provide a heat-resistant dicing tape or sheet which has excellent heat resistance, neither melts to deform nor considerably increases in adhesive force even through a heating step of about 200°C after application to an adherend, and can be easily peeled off after the accomplishment of the purpose of adhesion without contaminating the adherend.

Another object of the invention is to provide a process for producing semiconductor chips which includes a step in which the heat-resistant dicing tape or sheet of the invention is used to conduct dicing. Still another object of the invention is to provide a semiconductor chip obtainable by the process.

The present inventors made intensive investigations in order to overcome the problems described above. As a result, they have found that a dicing tape or sheet, which has excellent heat resistance and can be satisfactorily removed even after a heating step, can be obtained by using specific materials for constituting the substrate and pressure-sensitive adhesive layer of the dicing tape or sheet. The invention has been thus completed.

**DETAILED DESCRIPTION OF THE DETENTION**

Namely, the invention relates to the following items 1 to 7.

1. A heat-resistant dicing tape or sheet, which comprises:

a substrate having a glass transition temperature of 70°C or higher; and

at least one pressure-sensitive adhesive layer disposed on at least one side of the substrate, said pressure-sensitive adhesive layer having a degree of weight loss upon heating of less than 2% when the pressure-sensitive adhesive layer is heated from room temperature to 200°C at a rate of temperature increase of 2°C/min, wherein the pressure-sensitive adhesive layer has an adhesive force (peel rate: 300 mm/min; peel angle: 180°) of 0.5 N/20 mm or lower when the heat-resistant dicing tape or sheet is applied to a silicon mirror wafer, is subsequently heated at 200°C for 30 seconds, and is then cooled to 23°C.

2. The heat-resistant dicing tape or sheet according to item 1, which causes a silicon mirror wafer to have a surface carbon element proportion increase ΔC of 10% or less after the heat-resistant dicing tape or sheet is applied to the silicon mirror wafer, is subsequently heated at 200°C for 30 seconds followed by being cooled to 23°C, and is then peeled off from the silicon mirror wafer.

3. The heat-resistant dicing tape or sheet according to item 1 or 2,
wherein the pressure-sensitive adhesive layer comprises an acrylic polymer as a base polymer, and
wherein the acrylic polymer contains, as a monomer component, a monomer having an alkoxyl group in an amount of 5% by weight or more based on all the monomer components.

4. The heat-resistant dicing tape or sheet according to any one of items 1 to 3,
wherein the pressure-sensitive adhesive layer comprises an acrylic polymer as a base polymer, and
wherein the acrylic polymer contains, as a monomer component, a monomer having a group containing nitrogen atom in an amount of 3% by weight or more based on all the monomer components.

5. The heat-resistant dicing tape or sheet according to any one of items 1 to 4,
wherein the pressure-sensitive adhesive layer has a loss tangent tanδ at 25°C of 0.5 or lower and a loss tangent tanδ at 50°C of 0.15 or lower.

6. The heat-resistant dicing tape or sheet according to any one of items 1 to 5,
wherein the pressure-sensitive adhesive layer comprises a base polymer having a side chain, and
wherein 1% or more of all the side chains have a carbon-carbon double bond.

7. The heat-resistant dicing tape or sheet according to any one of items 1 to 6,
wherein the pressure-sensitive adhesive layer comprises a base polymer having a weight-average molecular weight of 500,000 or higher.

In the heat-resistant dicing tape or sheet of the invention, it is preferable that, when the heat-resistant dicing tape or sheet is applied to a silicon mirror wafer, subsequently heated at 200°C for 30 seconds and then cooled to 23°C, and then peeled off from the silicon mirror wafer, the silicon mirror wafer has a surface carbon element proportion increase ΔC of 10% or less.

The pressure-sensitive adhesive layer of the heat-resistant dicing tape or sheet of the invention can be constituted of an acrylic polymer as a base polymer. In this case, the acrylic polymer preferably contains, as a monomer component, a monomer having an alkoxyl group in an amount of 5% by weight or more based on all the monomer components. It is also preferred that the acrylic polymer contains, as a monomer component, a monomer having a group containing nitrogen atom in an amount of 3% by weight or more based on all the monomer components.

The pressure-sensitive adhesive layer of the heat-resistant dicing tape or sheet of the invention preferably has a loss tangent tanδ at 25°C of 0.5 or lower and a loss tangent tanδ at 50°C of 0.15 or lower.

The base polymer constituting the pressure-sensitive adhesive layer is preferably a polymer which has side chains and in which 1% or more of all the side chains have a carbon-carbon double bond. The base polymer preferably has a weight-average molecular weight of 500,000 or higher.

Furthermore, the invention relates to the following item 8.

8. A process for producing semiconductor chip, which comprises:

(1) adhering a semiconductor wafer to a heat-peelable tape or sheet, grinding the semiconductor wafer, and then adhering the heat-resistant dicing tape or sheet according to any one of items 1 to 7 to the side of said resultant thinned semiconductor wafer which is opposite to the side to which the heat-peelable tape or sheet is adhered;
(2) peeling off the heat-peelable tape or sheet by heating; and
(3) dicing the semiconductor wafer to prepare a chip of the semiconductor wafer.

Still furthermore, the invention relates to the following item 9.

9. A semiconductor chip obtainable by:

(1) adhering a semiconductor wafer to a heat-peelable tape or sheet, grinding the semiconductor wafer, and then adhering the heat-resistant dicing tape or sheet according to any one of items 1 to 7 to the side of said resultant thinned semiconductor wafer which is opposite to the side to which the heat-peelable tape or sheet is adhered;

(2) peeling off the heat-peelable tape or sheet by heating; and

(3) dicing the semiconductor wafer to prepare a chip of the semiconductor wafer.

The heat-resistant dicing tape or sheet of the invention has excellent heat resistance. Because of this, the dicing tape or sheet is less apt to deform upon heating and the pressure-sensitive adhesive is less apt to change in cohesive force or adhesive force. Consequently, even when it is applied to an adherend such as a semiconductor wafer and then heated to 200°C, the dicing tape or sheet is less apt to arouse troubles, for example, that the dicing tape deforms to break the adherend, the pressure-sensitive adhesive decreases in cohesive force, and the pressure-sensitive adhesive considerably increases in adhesive force and thereby becomes difficult to be removed from the adherend. Accordingly, the dicing tape or sheet of the invention does not contaminate the adherend surface upon removal therefrom, and can be easily and satisfactorily peeled off.

According to the process for producing semiconductor chip of the invention, the productivity and yield of semiconductor chips can be greatly improved because contamination to semiconductor chip by the pressure-sensitive adhesive of a dicing tape and breakage of semiconductor chip by dicing tape deformation are highly inhibited.

The semiconductor chip of the invention is considerably reduced in contamination by the pressure-sensitive adhesive of the dicing tape.

Heat-Resistant Dicing Tape or Sheet

The heat-resistant dicing tape or sheet of the invention has a structure including a substrate and a pressure-sensitive adhesive layer superposed on at least one side of the substrate. An appropriate separator may be disposed on the surface of the pressure-sensitive adhesive layer (pressure-sensitive adhesive side) according to need. The heat-resistant dicing tape or sheet may have an appropriate shape, such as a sheet form or roll form, according to applications thereof. For example, in the case of use in wafer dicing, a tape or sheet which has been cut into a given shape is preferred.

Substrate

As the substrate in the invention, use may be made of one which has a glass transition temperature of 70°C or higher in order to avoid thermal melting. One having a glass transition temperature of 70°C or higher can be suitably selected from conventional or common substrates. Although the substrate is not particularly limited, it is preferred to use a substrate made of an organic material such as a resin film, from the standpoint of workability in the step of cutting such as blade cutting or precutting in the processing of, e.g., a semiconductor wafer. Examples of the material constituting the substrate include polyesters such as poly(ethylene terephthalate) (PET), poly(ethylene naphthalate) (PEN), and poly(butylene terephthalate) (PBT); polyimides (PI); polyetherimides (PEI); poly(phenyl sulfate); amide resins such as polyamides and wholly aromatic polyamides (aramids); poly(vinyl chloride) (PVC); poly(phenylene sulfide) (PPS); polyetheretherketones (PEEK); polycarbonates (PC); polyethylene (PE); polypropylene (PP); olefin resins containing monomer units derived from one or more $\alpha$-olefins, such as ethylene/propylene copolymers and ethylene/vinyl acetate copolymers (EVA); fluororesins; and silicone resins. These materials can be used alone or in combination of two or more thereof

In the present invention, glass transition temperature (Tg) is defined by TMA (thermomechanical analyzer) inflection point according to the measurement using TMA (THASS/150C, manufactured by Seiko Instruments Inc.) under a condition at a rate of temperature increase of 2°C/min.

The substrate may have a single-layer constitution or a multilayer constitution. In the case where a pressure-sensitive adhesive of the ultraviolet curable type is to be used as the pressure-sensitive adhesive constituting the pressure-sensitive adhesive layer, it is preferred to use a substrate which does not inhibit ultraviolet from passing therethrough.

The thickness of the substrate is not particularly limited, However, from the standpoints of workability in the cutting step, incision by a dicing blade, etc., the thickness thereof can be selected within the range of, for example, 5 to 300 $\mu$m, preferably 25 to 200 $\mu$m, more preferably 35 to 200 $\mu$m.

For the purpose of improving adhesion to the pressure-sensitive adhesive layer, the surface of the substrate may have undergone an ordinary surface treatment such as a chemical or physical oxidation treatment, e.g., a chromic acid treatment, exposure to ozone, exposure to a flame, exposure to a high-tension electric shock, or treatment with an ionizing radiation. Furthermore, the surface of the substrate may have undergone a coating treatment with a primer or an anchor coat such as an isocyanate anchoring agent.

Pressure-Sensitive Adhesive Layer

The pressure-sensitive adhesive layer of the heat-resistant dicing tape or sheet of the invention has a degree of weight loss upon heating of less than 2%, preferably less than 1%, and more preferably less than 0.5%, when it is heated from room temperature (e.g., about 23°C) to 200°C at a rate of temperature increase of 2°C/min. The dicing tapes and the like for use in processing semiconductor chips or the like are required to have heat resistance so that even when the dicing tapes and the like are heated to high temperatures in a processing step, the pressure-sensitive adhesive properties do not considerably increase or decrease due to thermal deterioration or the cohesive force does not decrease. So long as the degree of weight loss upon heating of the pressure-sensitive adhesive layer is within the above-described range, this heat-resistant dicing tape or sheet can be judged to have heat resistance which makes the tape or sheet suitable for the intended use. The adhesive force of the pressure-sensitive adhesive layer is as follows. The dicing tape or sheet is applied to a silicon mirror wafer, and this wafer bearing the tape or sheet is heated to 200°C and then allowed to cool. Thereafter, the dicing tape or sheet is peeled off at $23\pm3$°C and a peel rate of 300 mm/min in such a way that the surface of the pressure-sensitive adhesive layer and the surface of the silicon mirror wafer form an angle of 180°. In this peeling, the adhesive force is 0.5 N/20 mm or lower, preferably 0.3 N/20 mm or lower. When the adhesive force thereof is 0.5 N/20 mm or lower, the dicing tape or sheet can have excellent releasability and the occurrence of adhesive remaining can be diminished. The degree of adhesive force of the pressure-sensitive adhesive layer can be increased or reduced within the above-mentioned range according to the intended use, and the like. In this regard, the reasons why the adhesive force of the pressure-sensitive adhesive layer is determined using a silicon mirror wafer are that the state concerning roughness of the surface of a silicon mirror wafer is a certain degree of smoothness and that the silicon mirror wafer is made of the same material as the semiconductor wafers or the like to be diced and picked up. Furthermore, the reason why the adhesive force is measured at a temperature of $23\pm3$°C is that pickup is usually conducted at room temperature (about 23°C).

It is preferred that the pressure-sensitive adhesive layer be constituted so that when it is applied to a silicon mirror wafer, subsequently heated at 200°C for 30 seconds, cooled to room temperature, and then peeled off, the resultant increase in surface carbon element proportion $\Delta C$ on the silicon mirror wafer surface is 10% or less, preferably 9% or less, and more preferably 5% or less. The surface carbon element proportion increase (%) is obtained by using, for example, an ESCA apparatus (X-ray photoelectron spectroscope) to determine the surface carbon element proportion $C_2$ (%) on the silicon wafer surface to which the dicing tape or the like has not been applied and the carbon element proportion $C_1$ (%) on the silicon wafer surface after application of the dicing tape thereto and removal of the tape therefrom; and calculating the difference between these found values using the equation $\Delta C = C_1 - C_2$. The value of the surface carbon element proportion increase $\Delta C$ (%) can be regulated so as to be 10% or less by regulating, for example, the molecular-weight distribution of the base polymer, number of carbon-carbon double-bond functional groups therein, amount of a crosslinking agent used, and the like. When the surface carbon element proportion increase $\Delta C$ is within the above-mentioned range, this dicing tape or sheet can be considered to satisfy the less contaminative properties required to pressure-sensitive adhesive sheets for processing electronic parts such as semiconductor chips. In the case where the pressure-sensitive adhesive layer is constituted of a pressure-sensitive adhesive of the energy ray curable type which will be described later, the value of surface carbon element proportion increase $\Delta C$ is one determined after energy ray irradiation and subsequent peeling.

The pressure-sensitive adhesive layer is not particularly limited so long as it satisfies the properties described above. For example, it can be constituted of a pressure-sensitive adhesive containing an acrylic polymer as a base polymer. The acrylic polymer preferably contains, as the main monomer, for example, an alkyl (meth)acrylate having an alkyl group containing 1 to 20 carbon atoms (preferably 2 to 16, more preferably 2 to 12 carbon atoms). Specific examples thereof include methyl (meth)acrylate, ethyl (meth)acrylate, propyl (meth)acrylate, isopropyl (meth)acrylate, butyl (meth)acrylate, s-butyl (meth)acrylate, t-butyl (meth)acrylate, pentyl (meth)acrylate, isopentyl (meth)acrylate, hexyl (meth)acrylate, heptyl (meth)acrylate, octyl (meth)acrylate, 2-ethylhexyl (meth)acrylate, isooctyl (meth)actylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicosyl (meth)acrylate. The alkyl (meth)acrylates include (meth)acrylic acid esters having an alicyclic hydrocarbon group, such as cyclohexyl (meth) acrylate and isobornyl (meth)acrylate. Such alkyl (meth)acrylates can be used alone or in combination of two or more thereof The content of alkyl (meth)acrylate is generally 60% by weight or higher based on all the monomer components constituting the acrylic polymer.

The acrylic polymer can contain other monomers (copolymerizable monomers) which are copolymerizable with the alkyl (meth)acrylates. By using a monomer including a specific structure as the copolymerizable monomer, desired properties such as, heat resistance or non-contaminative properties can be imparted to the pressure-sensitive adhesive.

For example, when a monomer having an alkoxyl group such as methoxyethyl (meth)acrylate or ethoxyethyl (meth)acrylate is used as a copolymerizable monomer, an acrylic polymer having alkoxyl groups as side chains can be obtained. Use of such a polymer as the base polymer of the pressure-sensitive adhesive has the following advantage. Even when the dicing tape or sheet is applied to an adherend surface on which active atoms are present, the acrylic polymer constituting the pressure-sensitive adhesive layer is inhibited from forming chemical bonds with those atoms. As a result, the dicing tape or sheet is inhibited from increasing in adhesive force with time after application to the adherend, and operations such as pickup can be smoothly performed even after the lapse of a long time from the application. The amount of the monomer having an alkoxyl group to be used can be selected in the range of 5% by weight or more (e.g., 5 to 3 5% by weight), preferably 10% by weight or more, more preferably 25% by weight or more, based on all the monomer components.

When a monomer having a group containing nitrogen atom is used as a copolymerizable monomer, an acrylic polymer having goups containing nitrogen-atom as side chains can obtained. Use of such a polymer in constituting a pressure-sensitive adhesive has an effect, for example, that the pressure-sensitive adhesive thus obtained has excellent heat resistance and is inhibited from suffering an abrupt decrease in elastic modulus even at a high temperature of, e.g., about 200°C. Specific examples of the copolymerizable monomer having a group containing nitrogen atom include (N-substituted) amide monomers such as (meth)acrylamide, N,N-dimethyl(meth)acrylamide, N-methylol(meth)acrylamide, N-methylolpropane(meth)acrylamide, N-hydroxymethyl(meth)acrylamide, 2-(meth)acrylamido-2-methylpropanesulfonic acid, and (meth)acrylamidopropanesulfonic acid; aminoalkyl (meth)acrylate monomers such as aminoethyl (meth) acrylate, N,N-dimethylaminoethyl (meth)acrylate, and t-butylaminoethyl (meth)acrylate; monomers having a nitrogen-atom-containing ring, such as N-vinylpyrrolidone, N-methylvinylpyrrolidone, N-vinylpyridine, N-vinylpiperidone, N-methylvinylpyrrolidone, N-vinylpyridine, N-vinylpiperidone, N-vinylpyrimidine, N-vinylpiperazine, N-vinylpyrazine, N-vinylpyrrole, N-vinylimidazole, N-vinyloxazole, N-vinylmorpholine, N-vinylcaprolactam, and (meth)acryloylmorpholine; maleimide monomers such as W-cyclohexylmaleimide, N-isopropylmaleimide, N-laurylmaleimide, and N-phenylmaleimide; itaconimide monomers such as N-methylitaconimide, N-ethylitaconimide, N-butylitaconimide, N-octylitaconimide, N-2-ethylhexylitaconimide, N-cyclohexylitaconimide, and N-laurylitaconimide; and succinimide monomers such as N-(meth)acryloyloxymethylenesuccinimide, N-(meth)acryloyl-6-oxyhexamethylsuccinimide, and N-(meth)acryloyl-8-oxyoctamethylenesuccinimide. It is desirable that the content of the monomer having a group containing nitrogen atom be 3% by weight or more, preferably 10% by weight or more, more preferably 20% by weight or more, based on all the monomer components.

Other examples of the copolymerizable monomers include carboxyl-containing monomers such as acrylic acid, methacrylic acid, maleic acid, fumaric acid, and crotonic acid; monomers containing an acid anhydride group, such as maleic anhydride and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfo-containing monomers such as styrenesulfonic acid, arylsulfonic acids, sulfopropyl (meth)acrylate, and (meth)acryloyloxynaphthalenesulfonic acid; and phosphate-group-containing monomers such as 2-hydroxyethyl acryloylphosphate. Furthermore, a polyfunctional monomer such as hexanediol di(meth)acrylate, (poly)ethylene glycol di (meth)acrylate, (poly)propylene glycol di(meth)acrylate, neopentyl glycol di(meth)acrylate, pentaerythritol tri(meth)acrylate, dipentaerythritol hexa(meth)acrylate, an epoxy (meth)acrylate, a polyester (meth)acrylate, or a urethane (meth) acrylate can be used for the purpose of crosslinking. Besides being used in order to regulate cohesive force, heat resistance, etc., those copolymerizable monomers are useful in the case where the pressure-sensitive adhesive is of the energy ray curable type as will be explained later.

One or more copolymerizable monomers can be selected and used. The amount of the copolymerizable monomers to be used is preferably 40% by weight or less based on all the monomer components.

The acrylic polymer can be obtained by polymerizing the monomers described above. The polymerization can be conducted by a conventional technique such as solution polymerization, emulsion polymerization, bulk polymerization, or suspension polymerization, and the technique to be used is not particularly limited. The acrylic polymer to be used as the base polymer of the pressure-sensitive adhesive is preferably one in which the content of low-molecular polymers is low, from the standpoint of preventing the pressure-sensitive adhesive from contaminating the adherend such as a semiconductor wafer. Consequently, the weight-average molecular weight of the acrylic polymer is generally 450,000 or higher, preferably 500,000 or higher (e.g., 500,000 to 3,000,000), more preferably 600,000 or higher (e.g., 600,000 to 3,000,000), especially preferably 800,000 or higher (e.g., 800,000 to 3,000,000). For regulating the weight-average molecular weight of the acrylic polymer so as to be within the above-mentioned range, kinds of the monomers and amounts thereof, temperature in the polymerization and other conditions are appropriately regulated. It is also possible to increase the weight-average molecular weight thereof by using an external crosslinking agent. As the external crosslinking agent, any conventional crosslinking agent can be used. Examples thereof include compounds having plural reactive functional groups, such as polyisocyanate compounds, epoxy compounds, aziridine compounds, melamine resins, urea resins, anhydride compounds including acid anhydrides, and polyamine compounds. In the case of using an external crosslinking agent, the amount of the crosslinking agent to be used can be suitably selected and determined so as to yield a polymer whose molecular weight, pressure-sensitive adhesive properties, and other properties are within desired ranges while taking account of a balance between this external crosslinking agent and the polymer to be crosslinked. For example, an amount thereof can be selected from the range of about 0.01 to 5 parts by weight with respect to 100 parts by weight of the base polymer.

It is preferred that the pressure-sensitive adhesive constituting the pressure-sensitive adhesive layer be constituted of a pressure-sensitive adhesive whose adhesive force can be reduced at a suitable point of time, such as a pressure-sensitive adhesive of the heat-peelable type or a pressure-sensitive adhesive of the energy ray curable type. This is because the dicing tape or sheet employing such a pressure-sensitive adhesive layer can tenaciously fix the adherend (e.g., semiconductor wafer) in a processing step such as back-side grinding and, after completion of the processing step, it can be easily peeled off without breaking the adherend or leaving an adhesive residue on the adherend. Examples of the energy rays include ultraviolet and electron beams.

The pressure-sensitive adhesive of the energy ray curable type can be prepared, for example, by using as a base polymer an energy-ray-polymerizable base polymer having energy-ray-polymerizable carbon-carbon double bonds. The carbon-carbon double bonds may be present in side chains of the polymer or may be present in the main chain thereof or at main-chain ends thereof, and the positions of the carbon-carbon double bonds are not particularly limited. Base polymers having carbon-carbon double bonds in side chains thereof are preferred because these polymers are advantageous from the standpoint of molecular design. For example, in the case where an acrylic polymer having carbon-carbon double bonds in side chains thereof is to be obtained, examples of usable methods include a method which includes: copolymerizing a copolymerizable monomer having a reactive functional group, such as a hydroxyl-containing monomer or carboxyl-containing monomer, in polymerization for acrylic-polymer production to thereby prepare beforehand an acrylic polymer having functional groups serving as base points for reaction; and causing this polymer to undergo a condensation or addition reaction with a compound having an energy-ray-polymerizable carbon-carbon double bond and a group capable of reacting with the functional groups in the acrylic polymer, while maintaining the energy ray curability of the carbon-carbon double bond. Examples of combinations of the reactive functional group to be introduced into the base polymer and the group capable of reacting with this functional group include a combination of carboxyl and epoxy, combination of carboxyl and aziridyl, and combination of hydroxyl and isocyanate. Of these combinations, the combination of hydroxyl and isocyanate is preferred from the standpoint of ease of following the reaction.

Specifically, an acrylic polymer having carbon-carbon double bonds in side chains thereof may be obtained, for example, by reacting an acrylic polymer having hydroxyl groups with an isocyanate compound having a carbon-carbon double bond. Examples of the acrylic polymer having hydroxyl groups include acrylic polymers containing the hydroxyl-containing monomers enumerated above and ether compounds such as 2-hydroxyethyl vinyl ether, 4-hydroxybutyl vinyl ether, and diethylene glycol monovinyl ether as monomer components. Specific examples of isocyanate compounds having an energy-ray-polymerizable carbon-carbon double bond include methacryloyl isocyanate, 2-methacryloyloxyethyl isocyanate, and m-isopropenyl-$\alpha,\alpha$-dimethylbenzyl isocyanate.

In the case where the acrylic polymer having energy-ray-polymerizable carbon-carbon double bonds in side chains thereof is used as the base polymer, it is preferred that 1% or more (e.g., 1 to 90%) of all the side chains each have a carbon-carbon double bond. More preferably, 10% or more (e.g., 10 to 85%) of all the side chains each have a carbon-carbon double bond. Especially preferably, 25% or ,ore (e.g., 25 to 75%) of all the side chains each have a carbon-carbon double bond. For introducing carbon-carbon double bonds into side chains in an amount within the above-mentioned range, use may be made of a method in which the amount of the compound having a carbon-carbon double bond to be caused to undergo an addition or condensation reaction with a base polymer is suitably regulated. Incidentally, the acrylic polymer may have carbon-carbon double bonds in both of side chains and the main chain thereof.

Besides being produced by the above-described method in which carbon-carbon double bonds are introduced into a base polymer, the pressure-sensitive adhesive of the energy ray curable type may be prepared by incorporating an energy-ray-curable compound (monomer or oligomer) into a base polymer. As the energy-ray-curable compound, use may be made of any compound which reacts upon irradiation with energy rays to form a crosslinked structure with the base polymer. However, it is preferred to use, for example, a compound (monomer or oligomer) having two or more carbon-carbon double bonds per molecule. Examples thereof include esters of (meth)acrylic acid with a polyhydric alcohol, such as trimethylolpropane tri(meth)acrylate, pentaerythritol tri(meth)acrylate, tetraethylene glycol di(meth)acrylate, 1,6-hexanediol (meth)acrylate, neopentyl glycol di(meth)acrylate, and dipentaerythritol hexa(meth)acrylate; ester acrylate oligomers; and cyanurate compounds such as 2-propenyl 3-butenyl cyanurate. Especially preferred of these are the compounds having 6 or more carbon-carbon double bonds per molecule, such as dipentaerythritol hexa(meth) acrylate. The viscosity or the like of such energy-ray-curable compounds are not particularly limited. One or two or more energy-ray-curable compounds can be selected and used.

In the case of using the energy-ray-curable compound, the amount of the compound to be incorporated is not particularly limited. The amount thereof can be suitably selected so that the pressure-sensitive adhesive layer comes to have a sufficiently reduced adhesive force in peeling off from a semiconductor wafer in the course of pickup (after curing of the pressure-sensitive adhesive). For example, the amount thereof can be selected within the range of 40 to 75%, preferably 50 to 70%, based on the weight of the whole pressure-sensitive adhesive. Alternatively, the amount of the compound can be selected within the range of 10 to 300 parts by weight, preferably 30 to 150 parts by weight, with respect to 100 parts by weight of the base polymer. The energy-ray-curable compound may be used together with the energy-ray-polymerizable base polymer described above.

When an energy-ray-polymerizable base polymer is used in preparing a pressure-sensitive adhesive of the energy ray curable type, there is no need of using an energy-ray-curable compound, which is a low-molecular ingredient, or the amount of this compound to be used can be considerably reduced even when it is used. Accordingly, a pressure-sensitive adhesive layer having a stable layer structure can be formed which is free from the trouble that a low-molecular ingredient migrates through the pressure-sensitive adhesive layer with time. Consequently, also from the standpoint of the property of less contamination to adherends, it is preferred to use an energy-ray-polymerizable base polymer.

A photopolymerization initiator is usually incorporated into pressure-sensitive adhesives of the energy ray curable type, in particular, pressure-sensitive adhesives of the ultraviolet curable type which undergo a polymerization/curing reaction upon irradiation with ultraviolet. Examples of the photopolymerization initiator include benzoin alkyl ethers such as benzoin methyl ether, benzoin isopropyl ether, and benzoin isobutyl ether, aromatic ketones such as benzil, benzoin, benzophenone, and $\alpha$-hydroxycyclohexyl phenyl ketone; aromatic ketals such as benzyl dimethyl ketal; and thioxanthone compounds such as polyvinylbenzophenone, chlorothioxanthone, dodecylthioxanthone, dimethylthioxanthone, and diethylthioxanthone. The amount of the photopolymerization initiator to be used can be selected within the range of, for example, about 0.1 to 10 parts by weight, preferably about 0.5 to 5 parts by weight, with respect to 100 parts by weight of the base polymer constituting the pressure-sensitive adhesive.

The pressure-sensitive adhesive constituting the pressure-sensitive adhesive layer may contain conventional or common additives such as a tackifier, antioxidant, filler, and the like, according to need besides the ingredients described above.

In producing the heat-resistant dicing tape or sheet of the invention, methods for forming the pressure-sensitive adhesive layer on a substrate are not particularly limited and conventional methods can be employed. Examples thereof include a method in which a pressure-sensitive adhesive is directly applied to a surface of a substrate and a method which includes applying a pressure-sensitive adhesive on a sheet which has undergone an appropriate releasant treatment, optionally drying the coating to form a pressure-sensitive adhesive layer, and then transferring the pressure-sensitive adhesive layer to a substrate.

The thickness of the pressure-sensitive adhesive layer is not particularly limited. However, it is preferably within the range of 1 to 50 $\mu$m, more preferably 3 to 20 $\mu$m. There are cases where a semiconductor wafer which has been adhered to a dicing tape vibrates when it is diced. In this case, when the amplitude of this vibration is large, the cut chips of the semiconductor wafer may chip. However, by regulating the thickness of the pressure-sensitive adhesive layer to 50 $\mu$m or smaller in the invention, the amplitude of the vibration occurring in semiconductor wafer dicing can be inhibited from becoming too large. As a result, chipping is diminished. By regulating the thickness of the pressure-sensitive adhesive layer to 1 $\mu$m or larger, a semiconductor wafer can be held without fail so as to prevent the wafer from readily separating from the pressure-sensitive adhesive layer during dicing. Thus, the occurrence of dicing failures can be prevented.

It is preferred that the pressure-sensitive adhesive layer have a loss tangent tan$\delta$, as measured at 25°C and a frequency of 1 Hz, of 0.5 or lower (e.g., 0.01 to 0.50, especially 0.01 to 0.40) and a loss tangent tan$\delta$, as measured at 50°C and a frequency of 1 Hz, of 0.15 or lower (e.g., 0.001 to 0.15, especially 0.01 to 0.12). When the loss tangent tan$\delta$ at 25°C thereof is 0.5 or lower and the loss tangent tan$\delta$ at 50°C thereof is 0.15 or lower, the dicing tape or sheet can retain satisfactory releasability even after long-term adhesion. On the other hand, when the loss tangent tan$\delta$ of the pressure-sensitive adhesive layer as measured at 25°C and a frequency of 1 Hz is 0.01 or higher and the loss tangent tan$\delta$ thereof as measured at 50°C and a frequency of 1 Hz is 0.001 or higher, then this pressure-sensitive adhesive layer can satisfactorily retain the property of wetting semiconductor wafers and void generation can be diminished. Incidentally, loss tangent tan$\delta$ is defined as tan$\delta$ = G''/G', wherein G' is the storage modulus of the pressure-sensitive adhesive layer and G'' is the loss modulus thereof.

The dicing tape or sheet of the invention may have a separator according to need. The separator has the functions of protecting the pressure-sensitive adhesive layer, labeling, and smoothing the surface of the pressure-sensitive adhesive layer. The material constituting the separator is not particularly limited. Examples thereof include paper and synthetic resin films made of polyethylene, polypropylene, poly(ethylene terephthalate), and the like. The surface of the separator may have undergone an appropriate release treatment, such as a silicone treatment, treatment with a long-chain alkyl type releasant, or fluorochemical treatment, so as to have enhanced releasability from the pressure-sensitive adhesive layer. Furthermore, in the case where the pressure-sensitive adhesive layer is constituted of a pressure-sensitive adhesive of the ultraviolet curable type or the like, the separator may have undergone an ultraviolet-shielding treatment so as to prevent the pressure-sensitive adhesive from reacting by the action of environmental ultraviolet. The thickness of the separator is not particularly limited. However, it is, for example, about 10 to 200 $\mu$m, preferably about 25 to 100 $\mu$m.

The heat-resistant dicing tape or sheet of the invention thus obtained can be used in a wide range of applications including a pressure-sensitive adhesive tape for the processing of electronic parts, and these applications are not particularly limited. In particular, the dicing tape or sheet can be advantageously used in operations which are accompanied by heat generation or include heating, so as to take advantage of the excellent heat resistance thereof. An especially suitable use is as a dicing tape or sheet in the process for semiconductor chip production of the invention which will be explained below in detail.

Process for Producing Semiconductor Chip

The dicing tape or sheet of the invention can be advantageously used as a dicing tape in cutting a semiconductor wafer into chips by dicing. In particular, since the dicing tape or sheet of the invention is less apt to deform/alter upon heating, it can be advantageously used in production steps including a heat treatment step and an operation step accompanied by heat generation, especially in semiconductor chip production steps. Examples of semiconductor chip production processes which can be practiced with the dicing tape or sheet of the invention include a process for producing semiconductor chips which includes the following series of steps:

(1) a step including adhering a semiconductor wafer to a heat-peelable tape or sheet, grinding the semiconductor wafer, and then adhering the heat-resistant dicing tape or sheet of the invention to the side of the resultant thinned semiconductor wafer which is opposite to the side to which the heat-peelable tape or sheet is adhered;
(2) a step of peeling off the heat-peelable tape or sheet by heating; and
(3) a step of dicing the semiconductor wafer to prepare chips of the semiconductor wafer.

Step (1) is a step in which the heat-resistant dicing tape or sheet of the invention is adhered to an adherend. The thinned semiconductor wafer as an adherend is one obtained by grinding a semiconductor wafer which is bonded to an appropriate heat-peelable tape or sheet (back grinding tape or sheet of the heat-peelable type) to have a desired thickness. In applying the heat-resistant dicing tape or sheet of the invention, the thinned semiconductor wafer is kept adhered to the heat-peelable tape or the like and the dicing tape or sheet is applied to that side of this semiconductor wafer which is opposite to the side to which the heat-peelable tape or sheet is adhered. Through this step, the thinned semiconductor wafer comes to be covered on one side with the heat-peelable tape or the like and covered on the other side with the heat-resistant dicing tape or sheet of the invention, thereby being in a multilayer state composed of the heat-peelable tape or sheet, the thinned semiconductor wafer, and the heat-resistant dicing tape or sheet of the invention laminated in this order.

Step (2) is a step in which the heat-peelable tape or sheet used in the step of thinning the semiconductor wafer is peeled off by heating. Although a heating temperature and a time in this step may be suitably selected according to the heat-peelable tape or sheet used, it is preferred to select a temperature not exceeding 200°C and a time not exceeding 30 seconds while taking account of the heat resistance of the heat-resistant dicing tape or sheet of the invention. Since the heat-resistant dicing tape or sheet of the invention is hardly deformed by heat, the semiconductor wafer is considerably inhibited from being damaged by a deformation of the dicing tape or sheet. Since the pressure-sensitive adhesive layer is less apt to be altered by heat, it retains moderate adhesive force and cohesive force throughout the period from before the heating step to after the heating step. Consequently, the pressure-sensitive adhesive layer tenaciously holds the semiconductor wafer in the subsequent step (3) in which the semiconductor wafer is cut into chips by dicing, and troubles such as chip scattering are less apt to arise. When the semiconductor chips formed by cutting are to be separated from the heat-resistant dicing tape or sheet, the semiconductor chips can be separated without being contaminated by the pressure-sensitive adhesive. Especially when the pressure-sensitive adhesive contains a pressure-sensitive adhesive capable of being easily reduced in adhesive force, such as a pressure-sensitive adhesive of the energy ray curable type, then the adhesive force of the pressure-sensitive adhesive can be reduced at any desired time and the semiconductor chips can be easily separated. Accordingly, the semiconductor chips produced are extremely less contaminated by the dicing tape or the like used in the processing step.

Steps (1), (2), and (3) described above may be successively conducted or may be separated by storage, transportation, or another step (e.g., a back-side metal deposition step). One or more other steps may be conducted before or after steps (1) to (3). Besides being used for semiconductor chips, the process for producing semiconductor chip of the invention is applicable to the dicing of semiconductor packages, glasses, ceramics, etc.

Examples

The invention will be explained below in more detail by reference to Examples, but the invention should not be construed as being limited by the following Examples.

EXAMPLE 1

As a substrate film was used a film made ofpoly(ethylene terephthalate) having a thickness of 50 μm (glass transition temperature, 78°C (measured by TMA)). One side of this film was subjected to a corona treatment.

Seventy-five parts by weight of methyl acrylate, 10 parts by weight of methoxyethyl acrylate, 10 parts by weight of N-vinylpyrrolidone, and 5 parts by weight of 2-hydroacyethyl acrylate were copolymerized in ethyl acetate in an ordinary manner. The NCO group of 2-methacryloyloxyethylene isocyanate was caused to undergo an addition reaction with 90% of the side-chain terminal OH groups derived from 2-hydroxyethyl acrylate in the copolymer obtained. Thus, a solution containing an acrylic copolymer having carbon-carbon double bonds introduced at side chains and having a weight-average molecular weight of 500,000 was obtained.

To the solution containing the acrylic copolymer were added 130 parts by weight of an ultraviolet-curable oligomer (viscosity at 25°C, 10 Pa-sec) obtained by reacting pentaerythritol triacrylate with a diisocyanate, 3 parts by weight of a photopolymerization initiator (trade name "Irgacure 651 "; manufactured by Ciba Specialty Chemicals Co.), and 2 parts by weight of a polyisocyanate compound (trade name "Coronate L"; manufactured by Nippon Polyurethane Co., Ltd.). Thus, an acrylic pressure-sensitive adhesive solution A of the ultraviolet curable type was obtained.

This acrylic pressure-sensitive adhesive solution A of the ultraviolet curable type was applied to the corona-treated side of the substrate film and heated/crosslinked at 80°C for 10 minutes. Thus, a pressure-sensitive adhesive layer of the ultraviolet curable type having a thickness of 5 μm was formed. Subsequently, a separator was bonded to the surface of this pressure-sensitive adhesive layer of the radiation curable type to produce a dicing tape of the ultraviolet curable type.

EXAMPLE 2

Seventy-five parts by weight of methyl acrylate, 10 parts by weight of methoxyethyl acrylate, 5 parts by weight of N-vinylpyrrolidone, and 10 parts by weight of 2-hydroxyethyl acrylate were copolymerized in ethyl acetate in an ordinary manner. The NCO group of 2-methacryloyloxyethylene isocyanate was caused to undergo an addition reaction with 90% of the side-chain terminal OH groups derived from 2-hydroxyethyl acrylate in the acrylic copolymer obtained. Thus, a solution containing an acrylic copolymer having carbon-carbon double bonds introduced at side chains and having a weight-average molecular weight of 600,000 was obtained.

To the solution containing the acrylic copolymer were added 130 parts by weight of an ultraviolet-curable oligomer (viscosity at 25°C, 10 Pa·sec) obtained by reacting pentaerythritol triacrylate with a diisocyanate, 3 parts by weight of a photopolymerization initiator (trade name "Irgacure 65 1 "; manufactured by Ciba Specialty Chemicals Co.), and 2 parts by weight of a polyisocyanate compound (trade name "Coronate L"; manufactured by Nippon Polyurethane Co., Ltd.). Thus, an acrylic pressure-sensitive adhesive solution B of the ultraviolet curable type was obtained.

A dicing tape of the ultraviolet curable type was produced by conducting the same procedure as in Example I, except that the acrylic pressure-sensitive adhesive solution B of the ultraviolet curable type was used in place of the acrylic pressure-sensitive adhesive solution A of the ultraviolet curable type.

COMPARATIVE EXAMPLE 1

Ninety-five parts by weight of methyl acrylate and 5 parts by weight of acrylic acid were copolymerized in ethyl acetate in an ordinary manner. Thus, a solution containing an acrylic copolymer having a weight-average molecular weight of 800,000 was obtained. To this solution containing the acrylic copolymer were added 130 parts by weight of an ultraviolet-curable oligomer (viscosity at 25°C, 10 Pa·sec) obtained by reacting pentaerythritol triacrylate with a diisocyanate, 3 parts by weight of a photopolymerization initiator (trade name "Irgacure 651"; manufactured by Ciba Specialty Chemicals Co.), and 2 parts by weight of a polyisocyanate compound (trade name "Coronate L"; manufactured by Nippon Polyurethane Co., Ltd.). Thus, an acrylic pressure-sensitive adhesive solution C of the ultraviolet curable type was obtained.

A dicing tape of the ultraviolet curable type was produced by conducting the same procedure as in Example 1, except that the acrylic pressure-sensitive adhesive solution C of the ultraviolet curable type was used in place of the acrylic pressure-sensitive adhesive solution A of the ultraviolet curable type.

COMPARATIVE EXAMPLE 2

A dicing tape of the ultraviolet curable type was produced by conducting the same procedure as in Example 1, except that poly(vinyl chloride) (glass transition temperature, 55°C) was used as a substrate.

TEST EVALUATION

The dicing tapes obtained in the Examples and Comparative Examples were subjected to the following test evaluation.

Adhesive Force after Heating

The dicing tape obtained in each of the Examples and Comparative Examples was cut into a strip form having a tape width of 20 mm. This dicing type was applied to the mirror surface of a silicon wafer (trade name "CZN<100>2.5-3.5 (4 inches)" manufactured by Shin-Etsu Handotai Co., Ltd.) and then heated on a hot plate at 200°C for 30 seconds. After this tape-bearing silicon wafer was cooled to room temperature (23°C), the dicing tape was irradiated with ultraviolet (irradiation time, 20 seconds; irradiation intensity, 500 mJ/cm$^2$) from the dicing-tape back side (substrate side). Thereafter, the dicing tape was peeled off at a peel angle of 180° and a peel rate of 300 mm/min to measure the adhesive force (peel force) of the dicing tape. The dicing tapes which had an adhesive force of 0.5 N/20 mm or lower were judged good, while those having an adhesive force higher than 0.5 N/20 mm were judged poor. The results obtained are shown in Table 1.

Determination of Degree of Weight Loss upon Heating

The pressure-sensitive adhesive obtained in each of the Examples and Comparative Examples was analyzed by TG/TGA to determine the degree of weight loss upon heating. In the examination, a sample was heated to 200°C at a rate of temperature increase of 2°C/min in an air atmosphere. The pressure-sensitive adhesives having a degree of loss less than 2% were judged good, while those having a degree of loss of 2% or more were judged poor. The results obtained are shown in Table 1.

Apparatus: TG/TGA200 (SII Nanotechnology)

Evaluation of Surface Carbon Element Proportion Increase ΔC on Mirror Silicon Wafer

Each of the dicing tapes obtained in the Examples and Comparative Examples was applied to the mirror silicon wafer and heated on a hot plate at 200°C for 30 seconds. This tape-bearing silicon wafer was then cooled to room temperature (23°C). Thereafter, the dicing tape was peeled off in the same manner as in the adhesive force measuring test. The silicon wafer surface from which the tape had been peeled was examined for surface carbon element proportion $C_1$ (%) with an ESCA apparatus. The original mirror silicon wafer surface was examined for surface carbon element proportion $C_2$ (%) with the ESCA apparatus. The examination conditions are as follows.

Subsequently, the surface carbon element proportion increase ΔC was calculated from the values of $C_1$ (%) and $C_2$ (%) using the following equation. Based on the results of the calculation, the dicing tapes in which ΔC was 10% or less were judged good, while those in which ΔC was larger than 10% were judged poor.

$$\Delta C\ (\%) = (\text{surface carbon element proportion } C_1\ (\%)) - (\text{surface carbon element proportion } C_2\ (\%))$$

<Examination Conditions in ESCA Surface Analysis>

Apparatus: Quantum 2000, manufactured by ULVAC-PHI Co.
X-ray setting: point analysis with $\phi$ of 200 $\mu$m [30 W (15 kV)]
X-ray source: monochromated AIK$_\alpha$
Photoelectron pickup angle: 45°

Loss Tangent tanδ of Pressure-Sensitive Adhesive Layer

The acrylic pressure-sensitive adhesive solutions A to C of the ultraviolet curable type prepared in the Examples and Comparative Examples each were applied to a separator and then dried at 100°C for 3 minutes to form a pressure-sensitive adhesive layer having a thickness of 50 $\mu$m on a dry basis. A 2-kg hand roller was used to evenly press the whole surface so that the total thickness of the separator and the pressure-sensitive adhesive layer became 3 mm, Subsequently, this sample was treated with an autoclave under the conditions of a temperature of 50°C and a pressure of 5 kg/cm$^2$ for the purpose of defoaming the sample. Thus, a sample for examining each pressure-sensitive adhesive layer was produced. A viscoelastic examination was conducted with "ARES" (trade name), manufactured by Rheometrics, Inc., under the conditions of $\omega$ = 1 Hz, a plate diameter $\phi$ of 7.9 mm, and a strain of 1% (25°C) in the temperature range of from -5°C to 75°C. The loss tangent tan$\delta$ was calculated from the found values of storage modulus G' and loss modulus G" at 25°C and 50°C, using the equation tan$\delta$ = G"/G'.

Comprehensive Evaluation

In comprehensive evaluation, the dicing tapes which were "good" with respect to all evaluation times, i.e., the degree of weight loss on heating, loss tangent tan$\delta$, adhesive force, and surface carbon element proportion increase $\Delta$C, were judged good, while the dicing tapes which were "poor" in at least one of the evaluation items were judged poor. As apparent from Table 1 below, it was ascertained that in the case of the dicing tapes of Examples 1 and 2, all semiconductor wafers could be satisfactorily separated even after the lapse of 6 hours and of 1 week from mounting, and that these dicing tapes had excellent suitability for pickup. It was further ascertained that the values of surface carbon element proportion increase $\Delta$C were slight and that these dicing tapes were effective in diminishing adhesive remaining and had excellent non-contaminative properties. In contrast, none of the dicing tapes of Comparative Examples 1 and 2 satisfied both of releasability and non-contaminative properties.

Table 1

| | | Example 1 | Example 2 | Comparative Example 1 | Comparative Example 2 |
|---|---|---|---|---|---|
| Adhesive force | Found value (N/20 mm) | 0.25 | 0.30 | 2.65 | unable to be measured due to substrate melting |
| | Judgment | good | good | poor | poor |
| Degree of weight loss on heating | Found value (%) | 1.6 | 1.4 | 1.3 | 1.6 |
| | Judgment | good | good | good | good |
| Loss tangent (tan$\delta$) | Found value at 25°C | 0.35 | 0.40 | 0.69 | 0.35 |
| | Found value at 50°C | 0.05 | 0,10 | 0.28 | 0.05 |
| Surface Found carbon element proportion increase ($\Delta$C) | value (%) | 4.9 | 7.4 | 21.0 | unable to be measured due to substrate melting |
| | Judgment | good | good | poor | poor |
| Comprehensive evaluation | | good | good | poor | poor |

While the invention has been described in detail and with reference to specific embodiments thereof, it will be apparent to one skilled in the art that various changes and modifications can be made therein without departing from the scope thereof.
This application is based on Japanese patent application No. 2006-195429 filed July 18, 2006, the entire contents thereof being hereby incorporated by reference.
Further, all references cited herein are incorporated in their entireties.

**Claims**

1.  A heat-resistant dicing tape or sheet, which comprises:

    a substrate having a glass transition temperature of 70°C or higher; and
    at least one pressure-sensitive adhesive layer disposed on at least one side of the substrate, said pressure-sensitive adhesive layer having a degree of weight loss upon heating of less than 2% when the pressure-sensitive adhesive layer is heated from room temperature to 200°C at a rate of temperature increase of 2°C/min,

wherein the pressure-sensitive adhesive layer has an adhesive force (peel rate: 300 mm/min; peel angle: 180°) of 0.5 N/20 mm or lower when the heat-resistant dicing tape or sheet is applied to a silicon mirror wafer, is subsequently heated at 200°C for 30 seconds, and is then cooled to 23°C.

2. The heat-resistant dicing tape or sheet according to claim 1, which causes a silicon mirror wafer to have a surface carbon element proportion increase ΔC of 10% or less after the heat-resistant dicing tape or sheet is applied to the silicon mirror wafer, is subsequently heated at 200°C for 30 seconds followed by being cooled to 23°C, and is then peeled off from the silicon mirror wafer.

3. The heat-resistant dicing tape or sheet according to claim 1,
wherein the pressure-sensitive adhesive layer comprises an acrylic polymer as a base polymer, and
wherein the acrylic polymer contains, as a monomer component, a monomer having an alkoxyl group in an amount of 5% by weight or more based on all the monomer components.

4. The heat-resistant dicing tape or sheet according to claim 1,
wherein the pressure-sensitive adhesive layer comprises an acrylic polymer as a base polymer, and
wherein the acrylic polymer contains, as a monomer component, a monomer having a group containing nitrogen atom in an amount of 3% by weight or more based on all the monomer components.

5. The heat-resistant dicing tape or sheet according to claim 1,
wherein the pressure-sensitive adhesive layer has a loss tangent tanδ at 25°C of 0.5 or lower and a loss tangent tanδ at 50°C of 0.15 or lower.

6. The heat-resistant dicing tape or sheet according to claim 1,
wherein the pressure-sensitive adhesive layer comprises a base polymer having a side chain, and
wherein 1% or more of all the side chains have a carbon-carbon double bond.

7. The heat-resistant dicing tape or sheet according to claim 1,
wherein the pressure-sensitive adhesive layer comprises a base polymer having a weight-average molecular weight of 500,000 or higher.

8. A process for producing semiconductor chip, which comprises:

   (1) adhering a semiconductor wafer to a heat-peelable tape or sheet, grinding the semiconductor wafer, and then adhering the heat-resistant dicing tape or sheet according to claim 1 to the side of said resultant thinned semiconductor wafer which is opposite to the side to which the heat-peelable tape or sheet is adhered;
   (2) peeling off the heat-peelable tape or sheet by heating; and
   (3) dicing the semiconductor wafer to prepare a chip of the semiconductor wafer.

9. A semiconductor chip obtainable by:

   (1) adhering a semiconductor wafer to a heat-peelable tape or sheet, grinding the semiconductor wafer, and then adhering the heat-resistant dicing tape or sheet according to claim 1 to the side of said resultant thinned semiconductor wafer which is opposite to the side to which the heat-peelable tape or sheet is adhered;
   (2) peeling off the heat-peelable tape or sheet by heating; and
   (3) dicing the semiconductor wafer to prepare a chip of the semiconductor wafer.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005116610 A

- JP 2006195429 A